# EUROPEAN PATENT APPLICATION

(11) **EP 4 582 870 A1**
(43) Date of publication of application: **09.07.2025**
(21) Application number: 23858719.0
(22) Date of filing: 06.05.2023
(51) Int. Cl.: G03F 7/004, G03F 7/20, G03F 7/00, C08G 83/00

(54) **ZN-BASED ORGANIC COORDINATION NANOPARTICLES AND PREPARATION METHOD THEREFOR, PHOTORESIST COMPOSITION, AND USE THEREOF**

(30) Priority: 29.08.2022 CN 202211050843
(71) Applicant: Tsinghua University, Beijing 100084 (CN); Beijing Vfortune New Energy Power Technology Development Co., Ltd., Beijing 100089 (CN)
(72) Inventor: XU, Hong, Beijing 100084 (CN); HE, Xiangming, Beijing 100084 (CN); TAO, Peipei, Beijing 100084 (CN)
(74) Representative: Lavoix
(86) International application number: PCT/CN2023/092497
(87) International publication number: WO 2024/045679

(57) **Abstract**

The present invention relates to a Zn-based organic coordination nanoparticles and a preparation method therefor, a photoresist composition, and use thereof. Zinc acetate, m-methylbenzoic acid and a nitrogen-containing organic ligand are mixed and stirred in an organic solvent, and are then subjected to a post-treatment to obtain a Zn-based organic coordination nanoparticles having a chemical general formula of [ZnₘXₙ(CH₃COO)ₜYₚH_{q}]ᵣ, wherein X is m-methylbenzoate; CH₃COO represents acetate; Y is the nitrogen-containing organic ligand; r is the degree of polymerization; m, n, p, q, n and r are each independently selected from any integer of 1 - 20; and t is selected from any integer of 0 - 20. In the present invention, the Zn-based organic coordination nanoparticles are used as a film-forming agent of a photoresist, and compared with an existing photoresists, the prepared photoresist has lithographic properties of a high resolution, a high sensitivity and a low line roughness.

## Description

### TECHNICAL FIELD

The invention relates to the technical field of photoresist, and in particular to a Zn-based organic coordination nanoparticle and a preparation method therefor, a photoresist composition and use thereof.

### BACKGROUND

Photoresists refer to the materials that, when irradiated by Ultra-Violet light, electron beam, particle beam, Extreme Ultra-Violet (EUV) or soft X-rays, etc., the solubility thereof differs in the irradiated area and in the non-irradiated area, so that the pattern of the mask is lithographed onto a silicon wafer to prepare integrated circuits. The smaller the size of the lithography lines of the photoresist is, the more transistors can be produced per unit area, thereby producing chips with better performance. Reducing the lithography wavelength is the most effective means to reduce the limit resolution of lithography. In the past 40 years, the light source of lithography machines has experienced the evolution from 436nm (G line), 365nm (I line), 248nm (KrF) to 193nm (ArF). As for separated 193nm, the technology node of a single exposure is 65nm. When an immersion lens is used to increase the numerical aperture, the technology node of a single exposure is increased by 33nm. At present, most chips from 5nm and 7nm processes are produced using immersion 193nm technology and multiple patterning overlay technology with multiple exposure. However, the patterning overlay accuracy of this process is difficult to control, the yield rate is low, and the cost is high. After nearly 10 years of research and development, the first Extreme Ultra-Violet lithography machine with a wavelength of 13.5nm in the world was developed in 2014. The theoretical technology node of a single exposure of 13.5nm lithography is 8nm, and theoretically chips with a 1nm process can be prepared.

The preparation of chips is inseparable from photoresist. Traditional photoresists have complex components, comprising a photoresist resin matrix, a photosensitive agent, a leveling agent, a stabilizer, a dispersant, a thickener and a solvent, etc. The manufacture process is tedious and requires extremely high control processes for the ratio and purity. Since traditional photoresists are mostly macromolecular polymers and contain many functional additives, their complex compositions lead to a wide distribution of photoresist sizes, with components of various sizes. Some size conformations can reach 10nm-20nm, making the size of photoresist patterns difficult to control and may cause many defects. In addition, for traditional photoresists, their application scope is greatly affected by the wavelength of the light source, and different photoresists are required to match different light sources.

Extreme Ultra-Violet (EUV) lithography has attracted attention as a basic technology for manufacturing next-generation semiconductor devices. EUV lithography is a pattern forming technology that uses EUV rays having a wavelength of about 13.5 nanometers as an exposure light source. According to EUV lithography, it is known that extremely fine patterns (e.g., less than or equal to about 20 nanometers) can be formed in an exposure process during the manufacture of semiconductor devices. However, in the prior art, the edge roughness of the pattern obtained by lithography is large and the pattern resolution is low, which is not conducive to the application of lithography technology. It is necessary to improve this.

### SUMMARY

### Technical Problem

Based on this, it is necessary to propose a new Zn-based organic coordination nanoparticle and a preparation method therefor, and a photoresist composition comprising the same and the use thereof to solve the problems of large edge roughness and low resolution of the pattern obtained by traditional photoresist lithography.

### Technical Solution

In one aspect, the present invention provides a Zn-based organic coordination nanoparticle, which is prepared by the following method: mixing and stirring a zinc salt, m-methylbenzoic acid and a nitrogen-containing organic ligand in an organic solvent, and then post-processing the mixture, wherein the molar ratio of the zinc salt, m-methylbenzoic acid and the nitrogen-containing organic ligand is (2-10): (4-10): (2-10).

The zinc salt may be selected from zinc acetate, zinc acetate dihydrate, zinc chloride, zinc sulfate, preferably zinc acetate or zinc acetate dihydrate.

Further, the zinc salt is zinc acetate.

Further, the nitrogen-containing organic ligand is any one or more of compounds selected from organic fatty amines and their derivatives, pyridine and its derivatives, pyrrole and its derivatives, pyrimidine and its derivatives, pyridazine and its derivatives, piperidine and its derivatives, amides and their derivatives.

Further, the nitrogen-containing organic ligand is selected from diethylamine, piperidine, diisopropylethylamine, and tetrahydropyrrole.

Further, the post-processing comprises: stirring at 45°C-80°C for 5-24h, then evaporating by rotation with a rotary evaporator at 40°C-60°C for 20 min-80 min, and then vacuuming in a vacuum oven at 45°C-75°C for 5h.

Further, the organic solvent is any one or more of ethyl acetate, butyl acetate, propylene glycol monoethyl ether acetate, propylene glycol methyl ether acetate, 1-ethoxy-2 propanol, methanol, ethanol, and propanol.

The preparation method of the above-mentioned Zn-based organic coordination nanoparticle for photoresist is as follows:

mixing and stirring a zinc salt, m-methylbenzoic acid and a nitrogen-containing organic ligand in an organic solvent and then post-processing the mixture, wherein the molar ratio of the zinc salt: m-methylbenzoic acid and the nitrogen-containing organic ligand is (2-10) :(4-10) :(2-10) , wherein the nitrogen-containing organic ligand is any one or more selected from organic fatty amines and their derivatives, pyridine and its derivatives, pyrrole and its derivatives, pyrimidine and its derivatives, pyridazine and its derivatives, piperidine and its derivatives, amides and their derivatives.

The zinc salt may be selected from zinc acetate, zinc acetate dihydrate, zinc chloride, zinc sulfate, preferably zinc acetate or zinc acetate dihydrate.

Further, the zinc salt is zinc acetate.

The second aspect of the present invention also provides a Zn-based organic coordination nanoparticle, having a chemical formula of [ZnₘXₙ(CH₃COO)ₜYₚH_{q}]ᵣ, where X is m-methylbenzoic acid, CH₃COO represents acetate, and Y is a nitrogen-containing organic ligand, r is a degree of polymerization, each of m, n, p, q, n and r is independently selected from any integer from 1 to 20, and t is selected from any integer from 0 to 20.

Y is further any one or more selected from organic fatty amines and their derivatives, pyridine and its derivatives, pyrrole and its derivatives, pyrimidine and its derivatives, pyridazine and its derivatives, piperidine and its derivatives, amides and their derivatives.

The organic fatty amines are any one or more selected from triisopropylamine, triethanolamine, dimethylamine, diethylamine, dipropylamine, diisopropylamine, and diisopropylethylamine; pyridine and its derivatives are any one or more selected from methylpyridine, vinylpyridine, methylpiperidine, perhydropyridine, α-pyridine, etc.; pyrrole and its derivatives are any one or more selected from tetrahydropyrrole, methylpyrrole, vinylpyrrole; pyridazine and its derivatives are any one or more selected from vinylpyridazine and divinylpyridazine; piperidine and its derivatives are any one or more selected from piperidine, vinyl piperidine and 3-methylpiperidine; amides and their derivatives are any one or more selected from formamide, stearamide, succinamide, oxalamide, acrylamide, and nicotinamide.

The present invention finds that the introduction of m-methylbenzoate ligand into the Zn-based organic coordination nanoparticle can effectively reduce the crystallinity of the complex, improve the solubility of the material in organic reagents, and facilitate storage and application.

Further, Y is selected from diethylamine, piperidine, diisopropylethylamine, and tetrahydropyrrole.

Further, each of m, n, p, q, n and r is independently an integer from 1 to 10, such as 1, 2, 3, 4, 5, 6, 7, 8, 9 or 10, and t is 0, 1, 2, 3, 4, 5, 6, 7, 8, 9 or 10.

Further, the size of the Zn-based organic coordination nanoparticle crystal is from 1 nm to 4 nm.

Further, the Zn-based organic coordination nanoparticle may have the following structure:
Zn₂(CH₃C₆H₄COO)₅(C₄H₁₁N)H, wherein C₄H₁₁N is diethylamine, and CH₃C₆H₄COO is m-methylbenzoate;
Zn₄(CH₃C₆H₄COO)₆(CH₃COO)₆(C₄H₉N)₄H₄, wherein C₄H₉N is tetrahydropyrrole;
Zn₃(CH₃C₆H₄COO)₇(CH₃COO)(C₅H₁₁N)₂H₂, wherein C₅H₁₁N is piperidine;
Zn₂(CH₃C₆H₄COO)₅(C₈H₁₉N)H, wherein C₈H₁₉N is diisopropylethylamine.

The invention also provides a method for preparing a Zn-based organic coordination nanoparticle, comprising the following steps: mixing and stirring zinc acetate, m-methylbenzoic acid and a nitrogen-containing organic ligand in an organic solvent and then post-processing the mixture, wherein the molar ratio of zinc acetate, m-methylbenzoic acid and the nitrogen-containing organic ligand is (2-10): (4-10): (2-10).

The present invention also provides a photoresist composition, comprising the above-mentioned nanoparticle.

Furthermore, the above-mentioned photoresist composition also comprises a photoacid agent and an organic dispersing solvent. The photoacid agent preferably makes up 5wt%-10wt% of the composition, and the nanoparticle preferably makes up 3wt%-20wt% of the composition.

Further, the photoacid agent is any one or more selected from N-hydroxynaphthalimide trifluoromethanesulfonic acid, 1,4-aminonaphthalene sulfonic acid, 2-amino-5,7-naphthalenedisulfonic acid, tert-butylphenyl iodonium perfluorooctane sulfonate, triphenylsulfonium perfluorobutanesulfonate, triphenylsulfonium perfluorobutyl and triphenylsulfonium trifluorosulfonate.

Further, the organic dispersing solvent is any one or more selected from ethyl acetate, butyl acetate, propylene glycol monoethyl ether acetate, propylene glycol methyl ether acetate, 1-ethoxy-2-propanol, methanol, ethanol, and propanol. The solvent is preferably ethyl acetate.

The present invention also provides a lithography method, which is characterized by using the above-mentioned photoresist composition, dripping the photoresist composition onto the substrate; rotating, heating and then exposing the substrate with electron beam, Mid-Ultra-Violet, Deep-Ultra-Violet or Extreme Ultra-Violet; and developing the substrate with a developing agent.

The exposure condition is any one selected from Mid-Ultra-Violet, Deep-Ultra-Violet, electron beam, and Extreme Ultra-Violet. The photoresist composition of the present invention can be used for any exposure conditions.

The substrate is selected from a silicon plate. Other substrates that are insoluble in a developing agent can also be selected according to actual needs.

Regarding the mask, a transmission mask is used for light sources of Deep-Ultra-Violet or longer wavelength, a reflection mask is used for Extreme Ultra-Violet, and the electron beam is used for the exposure according to the pattern set by the software.

Further, the exposure dose of Mid-Ultra-Violet, Deep-Ultra-Violet or Extreme Ultra-Violet is from 50mJ/cm² to 500mJ/cm², and the exposure dose of electron beam is from 50µC/cm² to 500µC/cm². The exposure dose should be controlled within an appropriate range. If the exposure dose is too small, the energy will be too low, which is not conducive to the polymerization of the photoresist particle in the exposed area, and is not conducive to the formation of the difference in solubility between the exposed area and the non-exposed area, and the development effect is poor. Compared with bare metal nanoparticles, the polymerization of nanoparticles containing organic ligands is easier to proceed. If the exposure dose is too large, the organic ligands may detach directly from the metal oxide to form fragments, and the photoresist particles can no longer undergo an exchange reaction of the organic ligands, thereby reducing the degree of polymerization in the exposed area.

Furthermore, the developing agent is selected from any one or a mixture of decalin, tetralin, indene, indane, quinoline, 1-methylnaphthalene, toluene, o-xylene, m-xylene, ethyl acetate, butyl acetate, ethanol, n-propanol, isopropyl alcohol, n-butanol, n-hexane and cyclohexane, and the developing temperature is room temperature or from 20°C to 50°C.

The thickness of the pre-film layer after removing the organic dispersing solvent may be 10nm-100nm. Specifically, the thickness of the pre-film layer may be 10nm-20nm, 20nm-30nm, 30nm-40nm, 40nm-50nm, 50nm-60nm, 60nm-70nm, 70nm -80nm, 80nm-90nm, or 90nm-100nm.

Further, the use of the above-mentioned nanoparticle in the field of photoresist, including photoresists for electron beam, Mid-Ultra-Violet, Deep-Ultra-Violet or Extreme Ultra-Violet, is provided.

### Beneficial Effects

The Zn-based organic coordination nanoparticle obtained by the present invention has a special structure and under illumination conditions, can interact with a photoacid generator (a photoacid agent), change the polarity of the material, and agglomerate, resulting in changes in the solubility of the Zn-based organic coordination nanoparticle before and after light exposure. Due to these characteristics, the Zn-based organic coordination nanoparticle can be used as a photoresist component to make the solubility of the photosensitive part and the light-shielding part of the photoresist in the developing agent different. The photosensitive part agglomerates in the developing agent and its solubility decreases, while the light-shielding part does not agglomerate and is dissolved in the developing agent, so that the non-exposed areas can be reshifted after development to obtain a pattern of the desired shape. In particular, due to the special structure of the Zn-based organic coordination nanoparticle, compared with traditional polymer photoresists and molecular glass photoresists, the size of the synthesized nanoparticle of the present invention is only about 2nm. The organic coordination nanoparticle, as a photoresist component, can achieve better lithography performance such as high resolution, high sensitivity, and low line roughness. Moreover, due to the presence of m-methylbenzoic acid, the crystallinity of the complex can be effectively reduced, the solubility of the material in organic reagents may be improved, and the storage and application may be facilitated.

### BRIEF DESCRIPTION OF THE DRAWINGS

FIG. 1 is a dynamic light scattering diagram of the Zn-based organic coordination nanoparticle according to Example 1 of the present invention.
FIG. 2A is a Hydrogen-1 Nuclear Magnetic Resonance (¹H NMR) Spectrum of the Zn-based organic coordination nanoparticle and raw materials according to Example 1 of the present invention.
FIG. 2B is an infrared spectrum of the Zn-based organic coordination nanoparticle according to Example 1 of the present invention.
FIG. 3 is a dynamic light scattering diagram of the Zn-based organic coordination nanoparticle according to Example 2 of the present invention.
FIG. 4A is a Hydrogen-1 Nuclear Magnetic Resonance Spectrum of the Zn-based organic coordination nanoparticle and raw materials according to Example 2 of the present invention.
FIG. 4B is an infrared spectrum of the Zn-based organic coordination nanoparticle according to Example 2 of the present invention.
FIG. 5 is a dynamic light scattering diagram of the Zn-based organic coordination nanoparticle according to Example 3 of the present invention.
FIG. 6A is a Hydrogen-1 Nuclear Magnetic Resonance Spectrum of the Zn-based organic coordination nanoparticle and raw materials according to Example 3 of the present invention.
FIG. 6B is an infrared spectrum of the Zn-based organic coordination nanoparticle according to Example 3 of the present invention.
FIG. 7 is a dynamic light scattering diagram of the Zn-based organic coordination nanoparticle according to Example 4 of the present invention.
FIG. 8A is a Hydrogen-1 Nuclear Magnetic Resonance Spectrum of the Zn-based organic coordination nanoparticle and raw materials according to Example 4 of the present invention.
FIG. 8B is an infrared spectrum of the Zn-based organic coordination nanoparticle according to Example 4 of the present invention.
FIG. 9A and FIG. 9B are the images of the exposed samples of the Zn-based organic coordination nanoparticle according to Example 1 of the present invention under Deep-Ultra-Violet of 254nm and under electron beam.
FIG. 10A and FIG. 10B are the images of the exposed samples of the Zn-based organic coordination nanoparticle according to Example 2 of the present invention under Deep-Ultra-Violet of 254nm and under electron beam.
FIG. 11A and FIG. 11B are the images of the exposed samples of the Zn-based organic coordination nanoparticle according to Example 3 of the present invention under Deep-Ultra-Violet of 254nm and under electron beam.
FIG. 12A and FIG. 12B are the images of the exposed samples of the Zn-based organic coordination nanoparticle according to Example 4 of the present invention under Deep-Ultra-Violet of 254nm and under electron beam.
FIG. 13 shows the difference in Extreme Ultra-Violet exposure performance of Example 1 of the present invention when it is first synthesized and after being left for two months.
FIG. 14 shows the difference in Extreme Ultra-Violet exposure performance of Comparative Example 1 of the present invention when it is first synthesized and after being left for two months.
FIG. 15 shows the difference in exposure performance of Comparative Example 2 of the present invention when it is first synthesized and after being left for two months.

### DETAILED DESCRIPTION OF THE PREFERRED EMBODIMENTS

### Example 1

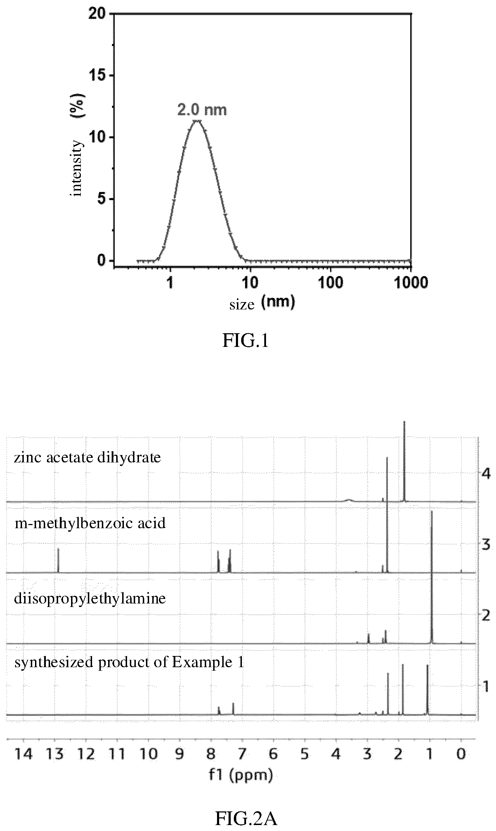

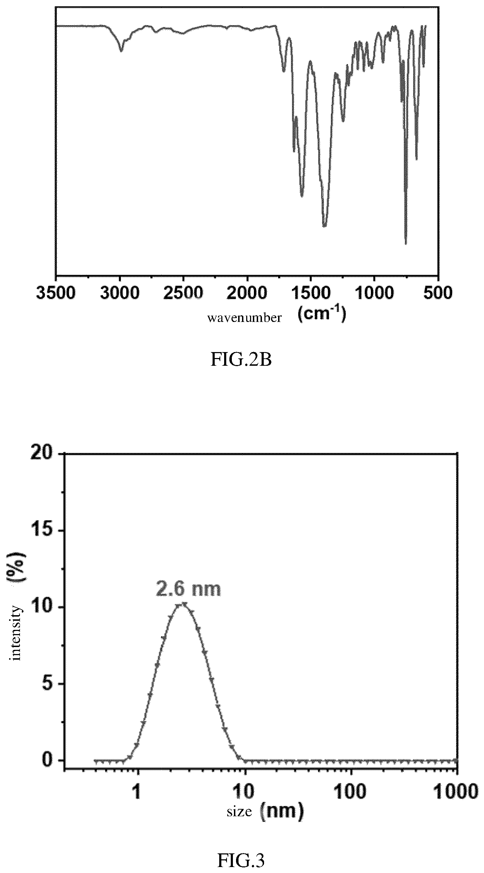

0.02 mol of zinc acetate, 0.04 mol of m-methylbenzoic acid, 0.03 mol of organic amine diisopropylethylamine and 45 mL of the solvent ethyl acetate were mixed and stirred evenly. The mixture was stirred at 65°C for 8h, was rotated and evaporated with a rotary evaporator at 50°C for 30 minutes, and then was evacuated in a vacuum oven at 65°C for 5 hours to obtain the synthesized product of Example 1. After analysis, the nanoparticle obtained in Example 1 comprised Zn₂(CH₃C₆H₄COO)₅(C₈H₁₉N)H. The ¹H NMR (600 MHz, DMSO-d6) δ of the nanoparticle is 7.77 - 7.75 (m), 7.75 - 7.70 (m), 7.31 - 7.26 (m), 3.29 - 3.21 (m), 2.73 (q), 2.34 (s), 1.87 (s), 1.08 (d). The particle size, the ¹H NMR Spectrum and Infrared Spectrum of the raw materials used and the obtained nanoparticle were characterized, as shown in FIG. 1, FIG. 2A and FIG. 2B. According to the NMR detection results: after the photoresist nanoparticle of Example 1 was synthesized, each of the monomers were coordinated respectively and peak shifts occurred. The peaks in the diisopropylethylamine structure shifted from 0.94, 2.42 and 2.96 to 1.08, 2.73 and 3.24 respectively; the peak of the methyl group in zinc acetate shifted from 1.82 to 1 .87; the peak of the methyl group in m-methylbenzoic acid shifted from 2.37 to 2.34, and the benzene ring peak also shifted from 7.39, 7.44 and 7.76 to 7.29, 7.73 and 7.76. It can be seen from FIG. 2B that the peaks at 1630 cm⁻¹, 1558 cm⁻¹ and 1370 cm⁻¹ correspond to the symmetric and asymmetric stretching of COO in the carboxyl group. At 820 cm⁻¹ -650 cm⁻¹ is the bending vibration peak of C-H in the aromatic ring of m-methylbenzoic acid. The vibration signals of the benzene ring skeleton are observed at 1600 cm⁻¹ and 1500 cm⁻¹ -1450 cm⁻¹. The peak at 621 cm⁻¹ is attributed to the stretching vibration of the Zn-O bond.

### Example 2

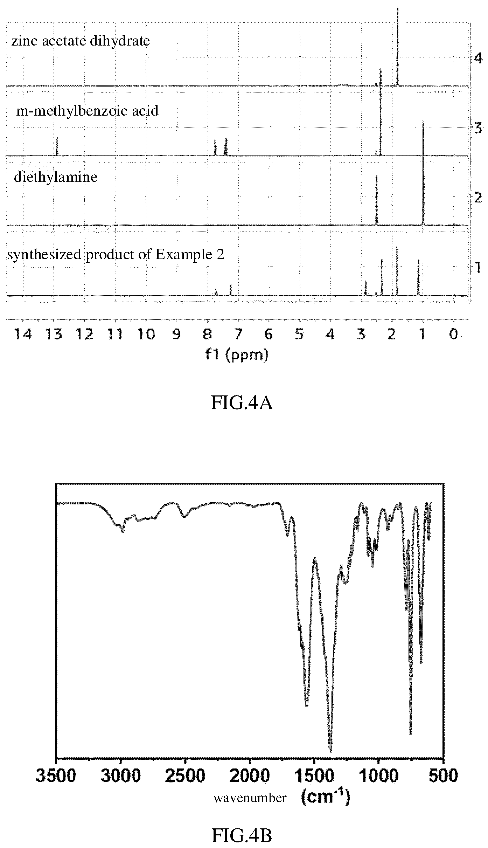

Different from Example 1, diethylamine was selected as the organic amine in Example 2, and the rest was the same as in Example 1 to obtain the synthesized product of Example 2. After analysis, the obtained nanoparticle comprised Zn₂(CH₃C₆H₄COO)₅(C₄H₁₁N)H. The particle size and the¹H NMR Spectrum of the raw materials used and the obtained nanoparticle were characterized, particularly as shown in FIG. 3, FIG. 4A and FIG. 4B. According to the NMR detection results: ¹H NMR (400 MHz, DMSO-d₆) δ 7.74 (d), 7.71 (dt), 7.30 - 7.22 (m), 2.86 (q), 2.33 (s,), 1.83 (s), 1.14 (t). After the photoresist nanoparticle of Example 2 was synthesized, each of the monomers was coordinated respectively and peak shifts occurred. The peaks in the diethylamine structure shifted from 0.98 and 2.50 to 1.14 and 2.86 respectively; the peak of the methyl group in zinc acetate shifted from 1.82 to 1.83; the peak of the methyl group in m-methylbenzoic acid shifted from 2.37 to 2.33, the peaks of the benzene ring also shifted from 7.39, 7.44 and 7.76 to 7.25, 7.71 and 7.74. It can be seen from FIG. 4B that the peaks at 1630 cm⁻¹, 1558 cm⁻¹ and 1370 cm⁻¹ correspond to the symmetric and asymmetric stretching of COO in the carboxyl group. At 820 cm⁻¹ -650 cm⁻¹ is the bending vibration peak of C-H in the aromatic ring of m-methylbenzoic acid. The vibration signals of the benzene ring skeleton are observed at 1600 cm⁻¹ and 1500 cm⁻¹-1450 cm⁻¹. The peak at 621 cm⁻¹ is attributed to the stretching vibration of the Zn-O bond.

### Example 3

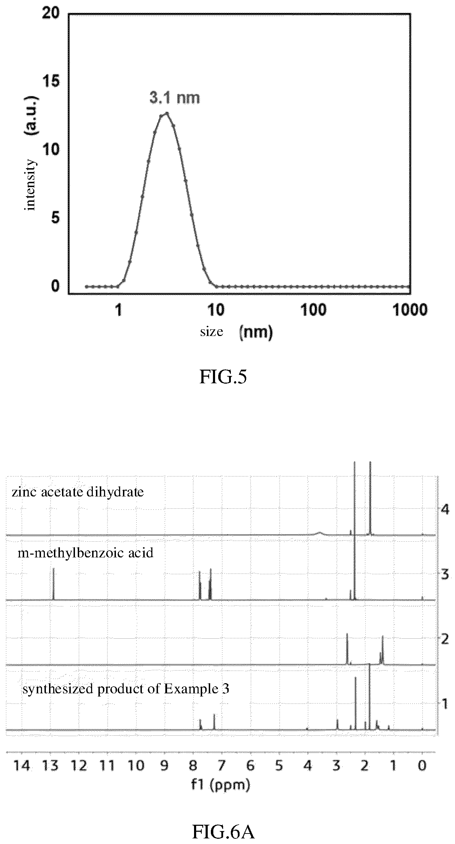

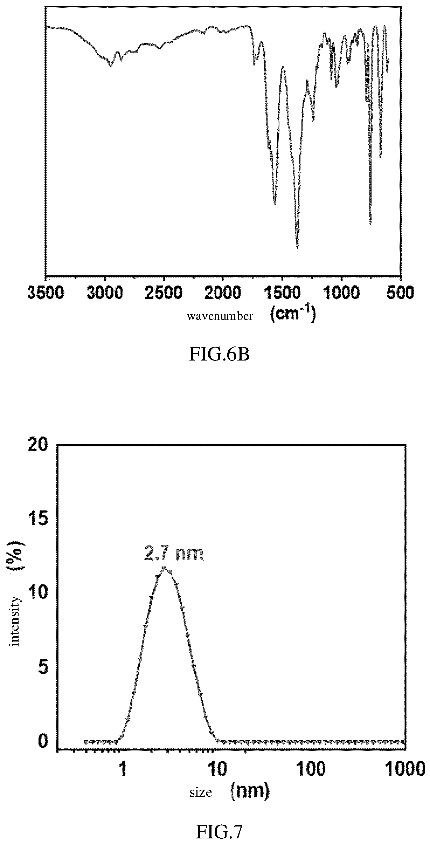

Different from Example 1, piperidine was selected as the organic amine in Example 3, and the rest was the same as in Example 1 to obtain the synthesized product of Example 3. After analysis, the obtained nanoparticle comprised Zn₃(CH₃C₆H₄COO)₇(CH₃COO)(C₅H₁₁N)₂H₂. The particle size and ¹H NMR Spectrum of the raw materials used and the obtained nanoparticle were characterized, particularly as shown in FIG. 5 and FIG. 6A and FIG. 6B. According to the NMR detection results: ¹H NMR (400 MHz, DMSO-*d*₆) δ 7.77 - 7.74 (m), 7.75 - 7.70 (m), 7.29 - 7.23 (m), 2.96 (t, *J =* 5.5 Hz), 2.33 (s ), 1.85 (s), 1.63 - 1.54 (m), 1.53 (s). After the photoresist nanoparticle of Example 3 was synthesized, each of the monomers was coordinated respectively, and peak shifts occurred. The peaks in the piperidine structure shifted from 1.35, 1.43 and 2.58 to 1.53, 1.59 and 2.96 respectively; the peak of the methyl group in zinc acetate shifted from 1.82 to 1.85; the peak of the methyl group in m-methylbenzoic acid shifted from 2.37 to 2.33, and the peak of the benzene ring also shifted from 7.39, 7.44 and 7.76 to 7.26, 7.73 and 7.75. It can be seen from FIG. 6B that the peaks at 1630 cm⁻¹, 1558 cm⁻¹ and 1370 cm⁻¹ correspond to the symmetric and asymmetric stretching of COO in the carboxyl group. At 820 cm⁻¹ -650 cm⁻¹ is the bending vibration peak of C-H in the aromatic ring of m-methylbenzoic acid. The vibration signals of the benzene ring skeleton are observed at 1600 cm⁻¹ and 1500 cm⁻¹ -1450 cm⁻¹. The peak at 621 cm⁻¹ is attributed to the stretching vibration of the Zn-O bond.

### Example 4

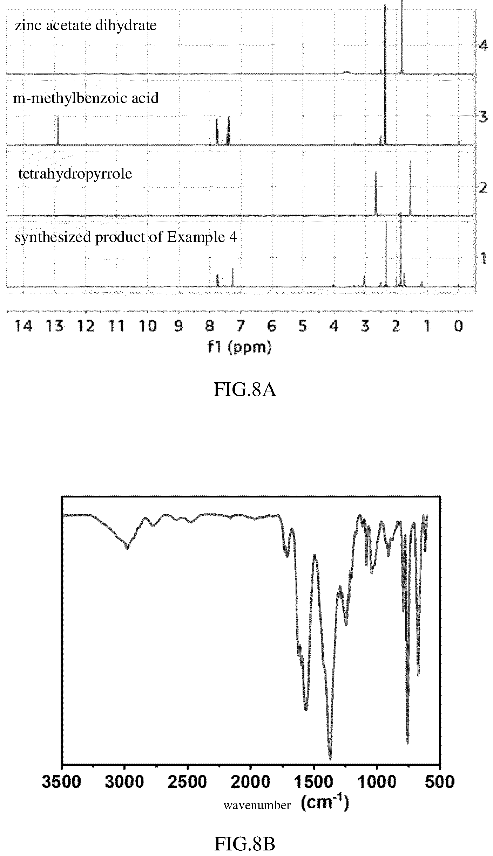

Different from Example 1, tetrahydropyrrole was selected as the organic amine in Example 4, and the rest was the same as in Example 1 to obtain the synthesized product of Example 4. After analysis, the obtained nanoparticle comprised Zn₄(CH₃C₆H₄COO)₆(CH₃COO)₆(C₄H₉N)₄ H. The particle size and ¹H NMR Spectrum of the raw materials used and the obtained nanoparticle were characterized, particularly as shown in FIG. 7, FIG. 8A and FIG. 8B. According to the NMR detection results: ¹H NMR (600 MHz, DMSO-*d*₆) δ 7.75 (dd), 7.72 (ddd), 7.32 - 7.24 (m), 3.03 (d), 2.34 (s), 1.85 (s), 1.75 (q). Each of the monomers was coordinated respectively, and peak shifts occurred. The peaks in the tetrahydropyrrole structure shifted from 1.54 and 2.66 to 1.75 and 3.03 respectively; the peak of the methyl group in zinc acetate shifted from 1.82 to 1.85; the peak of the methyl group in m-methylbenzoic acid shifted from 2.37 to 2.34, the peaks of the benzene ring also shifted from 7.39, 7.44 and 7.76 to 7.27, 7.72 and 7.75. It can be seen from FIG. 8B that the peaks at 1630 cm⁻¹, 1558 cm⁻¹ and 1370 cm⁻¹ correspond to the symmetric and asymmetric stretching of COO in the carboxyl group. At 820 cm⁻¹ -650 cm⁻¹ is the bending vibration peak of C-H in the aromatic ring of m-methylbenzoic acid. The vibration signals of the benzene ring skeleton are observed at 1600 cm⁻¹ and 1500 cm⁻¹ - 1450 cm⁻¹. The peak at 621 cm⁻¹ is attributed to the stretching vibration of the Zn-O bond.

### Example 5

The nanoparticle in Example 1 was dissolved with propylene glycol methyl ether acetate, the mass ratio of the nanoparticle in the composition was controlled to 5%, and then the photoacid N-hydroxynaphthalimide trifluoromethanesulfonic acid was added thereto, the mass of the photoacid made up 10% of the composition, the composition was stirred for 5 minutes until all the composition was dissolved completely to obtain a photoresist mixture solution.

The photoresist mixture solution was filtered twice with a filter head, then the silicon wafer was placed on a coater, the photoresist was dripped onto the silicon wafer, the rotational speed was set to 2000r/min, and the silicon wafer was rotated for 1 minute. Then, the silicon wafer was heated on a hot plate at 80°C for 1 minute. The exposure was performed under electron beam, Mid-Ultra-Violet, Deep Ultra-Violet, or Extreme Ultra-Violet. After exposure, the silicon wafer was developed with decahydronaphthalene for 10s-40s, and was blown dry with nitrogen.

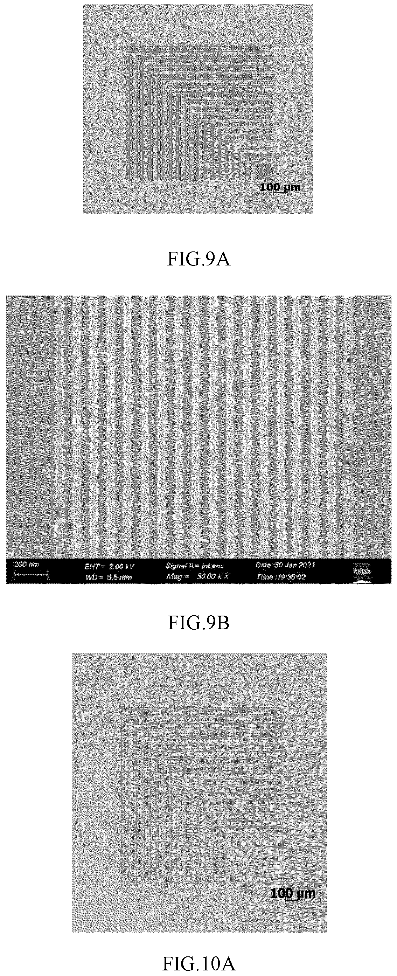

The obtained test patterns were shown in FIG. 9A and FIG. 9B. FIG. 9A shew that clear exposure patterns were obtained by the synthesized product of Example 1 under the conditions of Mid-Ultra-Violet (150 mJ/cm²) and electron beam (150 µC/cm²) (FIG. 9B).

### Example 6-9

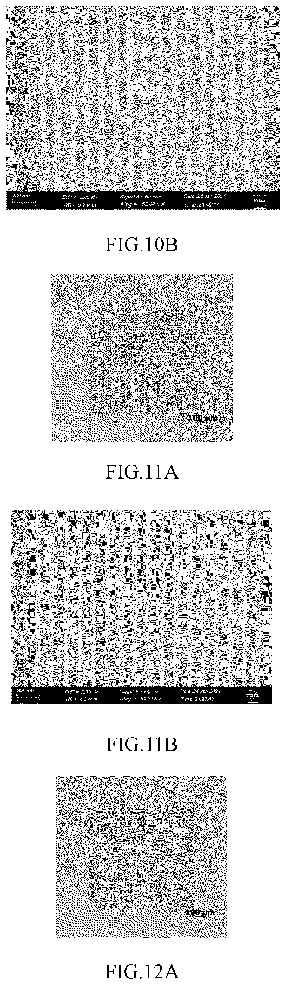

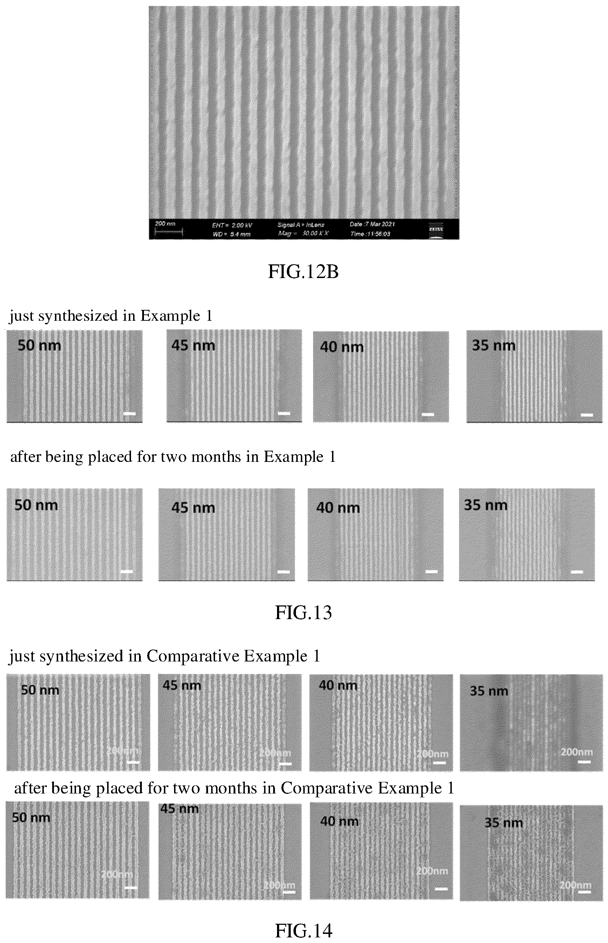

The nanoparticles obtained in Examples 2-4 were subjected to the lithography test, respectively, and the obtained patterns were shown in FIGs. 10A-12B. FIG. 10A and FIG. 10B shew the exposure patterns of the photoresist comprising the nanoparticle synthesized in Example 2 under the conditions of Mid-Ultra-Violet (150 mJ/cm²) and electron beam (150 µC/cm², 50nm), respectively. FIG. 11A and FIG. 11B were the exposure patterns of the photoresist comprising the nanoparticle synthesized in Example 3 under the conditions of Mid-Ultra-Violet (150 mJ/cm²) and electron beam (270 µC/cm², 50 nm), respectively. FIG. 12A and FIG. 12B were the exposure patterns of the photoresist comprising the nanoparticle synthesized in Example 4 under the conditions of Mid-Ultra-Violet (150 mJ/cm²) and electron beam (120 µC/cm², 50 nm), respectively.

### Comparative Example 1

For the preparation method in Example 1, m-methylbenzoic acid was replaced with benzoic acid to obtain a nanoparticle. The rest is the same as Example 1.

### Comparative Example 2

The organic amine in the preparation method in Example 1 was replaced with triethylamine to obtain a nanoparticle. The rest is the same as Example 1.

### Example 10

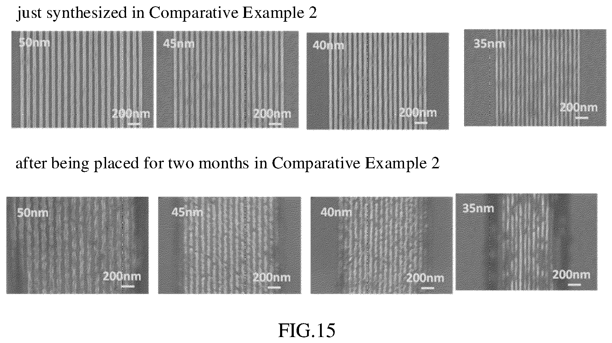

For Example 1 and Comparative Examples 1 and 2, exposure was performed under EUV (with exposure condition 200mJ/cm²), and the exposure patterns as shown in FIGs. 13-15 were obtained after 2 months. From the patterns, it can be seen that, when the nanoparticle of Example 1 was just synthesized: the lines were not bridged, the contrast was good; and two months later, the lines were not bridged basically, and the contrast was good.

When the nanoparticle of Comparative Example 1 was just synthesized: the lines were not bridged basically, and the contrast was good; and two months later, the lines were bridged, and the contrast was slightly worse. When the nanoparticles of Comparative Example 2 were just synthesized: the lines were bridged, the contrast was slightly worse; and two months later, the lines were severely adhered, there were more fractures, and the contrast was worse. It can be seen that the nanoparticles in this application are better in stability than those of Comparative Examples 1-2.

In view of above, the present invention obtains four effective nanoparticles, verifies their particle size distributions and good lithography performances under the conditions of Deep-Ultra-Violet lithography at a wavelength of 254nm and electron beam lithography, which can achieve better lithography performance such as high resolution, high sensitivity, and low line roughness, and proves that m-methylbenzoic acid as a ligand can improve the stability of nanoparticles in lithography.

## Claims

1. A Zn-based organic coordination nanoparticle, having a chemical formula of [ZnₘXₙ(CH₃COO)ₜYₚH_{q}H_{q}]ᵣ, wherein X is m-methylbenzoic acid, CH₃COO represents acetate, Y is a nitrogen-containing organic ligand, r is a degree of polymerization, each of m, n, p, q, n and r is independently selected from any integer from 1 to 20, and t is selected from any integer from 0 to 20.

2. The nanoparticle according to claim 1, wherein Y is any one or more selected from organic fatty amines and their derivatives, pyridine and its derivatives, pyrrole and its derivatives, pyrimidine and its derivatives, pyridazine and its derivatives, piperidine and its derivatives, and amides and their derivatives.

3. The nanoparticle according to claim 1, wherein Y is selected from diethylamine, piperidine, diisopropylethylamine, and tetrahydropyrrole.

4. The nanoparticle according to any one of claims 1 to 3, wherein each of m, n, p, q, n and r is independently an integer between 1-10, such as 1, 2, 3, 4, 5, 6, 7, 8, 9 or 10, and t is 0, 1, 2, 3, 4, 5, 6, 7, 8, 9 or 10.

5. The nanoparticle according to any one of claims 1 to 3, wherein the size of the Zn-based organic coordination nanoparticle crystal is from 1nm to 4nm.

6. The nanoparticle according to any one of claims 1 to 3, wherein the Zn-based organic coordination nanoparticle has a structural formula of:
Zn₂(CH₃C₆H₄COO)₅(C₄H₁₁N)H, wherein C₄H₁₁N is diethylamine, and CH₃C₆H₄COO is m-methylbenzoate; or
Zn₄(CH₃C₆H₄COO)₆(CH₃COO)₆(C₄H₉N)₄H₄, wherein C₄H₉N is tetrahydropyrrole; or
Zn₃(CH₃C₆H₄COO)₇(CH₃COO)(C₅H₁₁N)₂H₂, wherein C₅H₁₁N is piperidine; or
Zn₂(CH₃C₆H₄COO)₅(C₈H₁₉N)H, wherein C₈H₁₉N is diisopropylethylamine.

7. A method for preparing a nanoparticle according to any one of claims 1 to 6, comprising:
mixing and stirring zinc acetate, m-methylbenzoic acid and a nitrogen-containing organic ligand in an organic solvent; and
post-treating the mixture to obtain the nanoparticle, wherein the molar ratio of zinc acetate: m-methylbenzoic acid and the nitrogen-containing organic ligand is (2-10): (4-10): (2-10).

8. A photoresist composition, comprising the nanoparticle according to any one of claims 1 to 6.

9. The photoresist composition according to claim 8, further comprising a photoacid agent and an organic dispersing solvent, wherein the photoacid makes up 5 wt%-10wt% of the composition, and the nanoparticle makes up 3wt%-20wt% of the composition.

10. The photoresist composition according to claim 9, wherein the photoacid agent is any one or more selected from N-hydroxynaphthaleneimide trifluoromethanesulfonic acid, 1,4-aminonaphthalenesulfonic acid, 2-amino-5,7-naphthalene disulfonic acid, tert-butylphenyl iodonium perfluorooctanesulfonic acid, triphenylsulfonium perfluorobutanesulfonic acid, triphenylsulfonium perfluorobutyl and triphenylsulfonium trifluorosulfonic acid.

11. The photoresist composition according to claim 9, wherein the organic dispersing solvent is any one or more selected from ethyl acetate, butyl acetate, propylene glycol monoethyl ether acetate, propylene glycol methyl ether acetate, 1-ethoxy-2-propanol, methanol, ethanol and propanol.

12. A lithography method, comprising:
using the photoresist composition according to any one of claims 9 to 11;
dripping the photoresist composition onto a substrate;
rotating and heating the substrate, and then exposing the substrate with an electron beam, Mid-Ultra-Violet, Deep-Ultra-Violet or Extreme Ultra-Violet; and
developing the substrate with a developing agent.

13. The lithography method according to claim 12, wherein the exposure dose of Mid-Ultra-Violet, Deep-Ultra-Violet or Extreme Ultra-Violet is 50mJ/cm²∼500mJ/cm², and the exposure dose of electron beam is 50µC/cm²∼500µC/cm².

14. The lithography method according to claim 12, wherein the a developing agent is any one selected from decalin, tetralin, indene, indane, quinoline, 1-methylnaphthalene, toluene, o-xylene, m-xylene, ethyl acetate, butyl acetate, ethanol, n-propanol, isopropanol, n-butanol, n-hexane and cyclohexane, or any mixture thereof; and the developing temperature is room temperature, or 20°C∼50°C.

15. Use of the nanoparticle according to any one of claims 1 to 6, in the field of photoresist, including photoresists for electron beam, Mid-Ultra-Violet, Deep-Ultra-Violet or Extreme Ultra-Violet.
